# EUROPEAN PATENT APPLICATION

(11) **EP 2 787 640 A1**
(43) Date of publication of application: **08.10.2014**
(21) Application number: 13162421.5
(22) Date of filing: 05.04.2013
(51) Int. Cl.: H03K 5/156, G06F 1/04

(54) **A wide range programmable duty cycle corrector**

(71) Applicant: Technische Universität Darmstadt, 64285 Darmstadt (DE)
(72) Inventor: Jaiswal, Ashok, 64295 Darmstadt (DE); Hofmann, Klaus, 64291 Darmstadt (DE); Yuan, Fang, 64283 Darmstadt (DE)
(74) Representative: Stumpf, Peter

(57) **Abstract**

A method and a device for correcting a duty cycle error of a clock signal are suggested. The method may be implemented using a programmable charge pump and/or a programmable buffer chain along with control device to provide output duty cycle of 50% for wide operating frequency and input duty cycle range. Where the programmable charge pump is an electronic device with programmable current sources; adjusting the sizes of current source devices is controlled by digitally decoded bits. Digitally decoded bits may be generated by converting the output of programmable charge pump to digital bits using an electronic device ADC and decoding the output of ADC using a combinational device. Where the programmable buffer chain is an electronic device using programmable inverters connected in series; adjusting the sizes of inverters is controlled by information bit carrying the information of operating frequency region. Where the information bit may be generated internally in the same device or can be generated from different electronic device. The information bit may also be used in combinational device for different operating frequency range.

## Description

The invention relates to the synchronous electronic systems where a wide frequency and wide input duty range duty cycle corrector (DCC) is used to correct the duty cylce (on time) of the input clock to 50%.

In general synchronous electronic systems at a duty cycle (on time per clock period) of 50% are required to have good setup and hold timing margin at high speed. DDR systems such as DDR3, GDDR5, XDR which work on both rising and falling edge of clocks, have stringent requirement on the duty cycle. A duty cycle error of 5% may lead to 10% performance degradation. Multi-phase clocking systems also require symmetrical wave shapes which demands a precise 50% duty cycle. Furthermore, the clock distribution with different components like buffers, inverters detoriates the clock duty cycle due to PVT (process, voltage, temperature) variations, inaccurate modeling etc.

Different approaches have been invented to detect the duty cycle error and then controlling it by using different techniques. In US patent no. 6501313B2 and 6664834, the body voltage of inverter transistors is controlled to change the threshold voltage in turn current to correct duty cycle to 50%. A digital as well as an analog control has been presented. Main drawback is the body bias noise and separate controls for NMOS and PMOS transistors. The body bias noise at high speed can create false logic. Separate controls for NMOS and PMOS leads to more area and power. If separate control varies due to PVT variation, it will lead to a wrong output duty cycle.

In US patent no. 20050058233, common mode detector (low pass filter) is used to generate operating dc voltage which is compared with predetermined reference voltage for particular required duty cycle (50%). The comparator output gives an error voltage which is converted into digital bits and further coded to adjust the bias current of differential amplifier to control the slew rate which further corrects the duty cycle. Reference voltage should be ideal which is necessary to find the difference between actual input duty cycle to required 50%. There are further sources of addition error generated by non-ideal comparator and quantization error produced by ADC (Analog to Digital converter). Due to PVT variations, it may be that errors are too large and leads to incorrect output duty cycle. This prior art has drawback to correct only small range of input duty cycle error (10%) as controlling tail current by adjusting size of tail transistors only changes slew rate (rise time, fall time).

All of the mentioned techniques have limitations to work at high frequency range and to correct large input duty cycle errors. It would, therefore, be desired, to devise an improved duty cycle corrector for synchronous systems which can serve wide frequency range and can correct wide input duty cycle error.

### Summary of the invention

In one preferred embodiment of the method, It is suggested to perform a method for correcting a duty cycle of a clock signal in a synchronous system that comprises a main clocking signal, control device, buffer chain and a programmable charge pump, wherein a duty cycle is detected by output voltage of the charge pump with known characteristics and consecutively converted into digital information using a ADC and combinational logic which in turn control the current sources of the programmable charge pump. As the unity gain bandwidth product is 1 (constant) for the loop system, If the gain is reduced, the bandwidth can be increased. By adjusting the current sources of the programmable charge pump, the gain of the charge pump is reduced and the bandwidth of the charge-pump is increased so that duty cycle correction can be performed for wide frequency range. The output of the charge pump is fed back to the control device which controls the charging and discharging currents of the control device. If the feedback signal (output of the programmable charge pump) reduces, the charging current increases and the discharging current decreases, hence the output duty cycle increase. Similarly if the feedback signal (output of the programmable charge pump) increases, the charging current decreases and the discharging current increases, hence the output duty cycle decreases. The buffer chain takes the control device output and converts it to full swing clocking signal (varying between ground and supply voltage) with corrected duty cycle of 50%. In this embodiment, the buffer chain designed in classical way (increasing sizes of the consecutive inverters) will reach its limitation when operating frequency is increased beyond a particular point as the gate capacitances of the large inverters cannot be charged and discharged properly by previous inverter in a short span of time.

According to another preferred embodiment of the method, the buffer chain is also made programmable to overcome its limitation at high frequency. An additional information bit which carries information of operating frequency region is used to control the sizes of the inverters in the programmable buffer chain. In this way, the duty cycle of the clocking signal can be corrected at very high frequency.

In the above mentioned embodiments, the standard circuit topology which is obvious to a person, skilled in the art is used and thus enables high yield. The most parts of the embodiments are digital which can be realized with low power supply. Mentioned embodiments can easily be scaled to advanced technologies which may increase operating frequency and input duty cycle range for which duty cycle can be corrected to 50%.

### Description of the Drawings

The present invention and its advantages will become more apparent, when looking at the following description of possible embodiments of the invention, which will be described with reference to the accompanying figures, which are showing:
FIG. 1 shows Prior art.
FIG. 2 shows the loop analysis of FIG. 1.
FIG. 3 shows charge pump used in FIG. 1.
FIG. 4 shows the charge pump output (Vctrl) behavior with duty cycle and frequency variation.
FIG. 5 shows an embodiment of the proposed method using programmable charge pump.
FIG. 6 shows the output duty cycle with and without proposed method in FIG. 5 from 3 GHz to 5 GHz operating frequency range with 70% input duty cycle.
FIG.7 shows another embodiment of the proposed method with programmable charge pump and programmable buffer chain.
FIG. 8 shows the charge pump output (Vctrl) behavior for 6 GHz and 7GHz.
FIG. 9 shows the output duty cycle with and without proposed method in FIG. 7 from 3 GHz to 7 GHz with 70% input duty cycle.

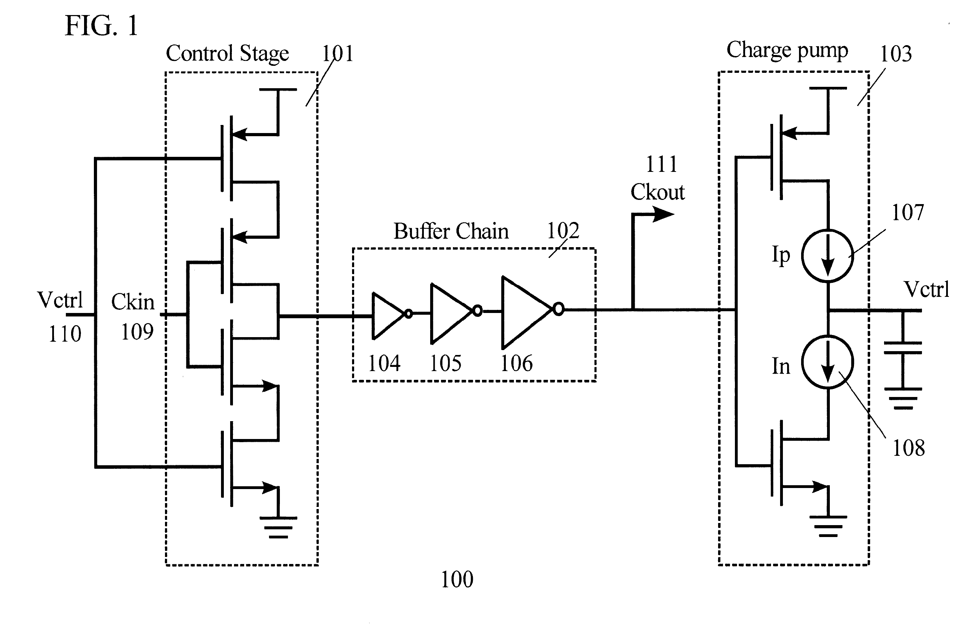

FIG. 1 illustrates prior art which consists of three stages: The control stage 101, the buffer chain 102, and the charge pump 103. The control stage 101 is a simple push-pull structure where charging and discharging path are controlled by Vctrl 110 voltage level. The duty cycle of the input clock (Ckin 109) increases (or decreases) depending upon the Vctrl 110 level. This push-pull structure leads to faster locking time as it adjusts the rising and falling simultaneously and doubles the gain. The buffer chain 102 is the classical inverter chain where increasing sizes of consecutive inverters (104, 105, 106) are used. The Buffer chain 102 converts the output of the control stage 101 to the full swing signal Ckout 111 which is the output clock signal with corrected duty cycle of 50%. There are mainly 2 drawback of this prior art 100; the first is the frequency range limit (maximum 2.5 GHz) due to its structure and second is that one need to increase the power supply to work at higher frequency i.e. 1.3 V for 800 MHz and 1.8 V for 2.5 GHz due to the caccode structure. Our invention overcomes both the problem. It achieves higher frequency range (up to 7 GHz) with same power supply of 1.2 V.

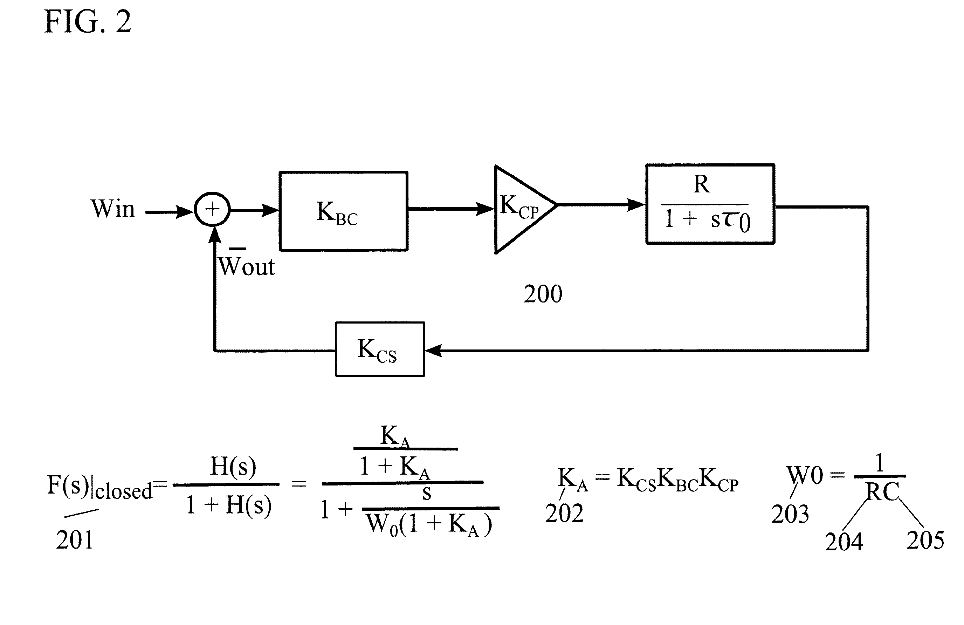

FIG. 2 is the transfer function analysis of FIG 1 where K_{CS} is the sensitivity of the control stage, K_{BC} is the gain of the clock buffer chain, K_{CP} is the gain of charge pump, Wₒᵤₜ is the target pulse width of the output clock signal and Wᵢₙ is the pulse width of input clock signal. R 204 and C 205 are the equivalent output resistance of the charge pump and the output capacitance of the charge pump respectively. Equation 201 shows the closed loop transfer function of FIG. 1. From Equation 202 and Equation 203, the parameters W₀ and K_{A} are dependent on R 204. To reduce the open loop gain K_{A}, R 204 has to be decreased to increase the bandwidth which in turn increases the operating frequency range.

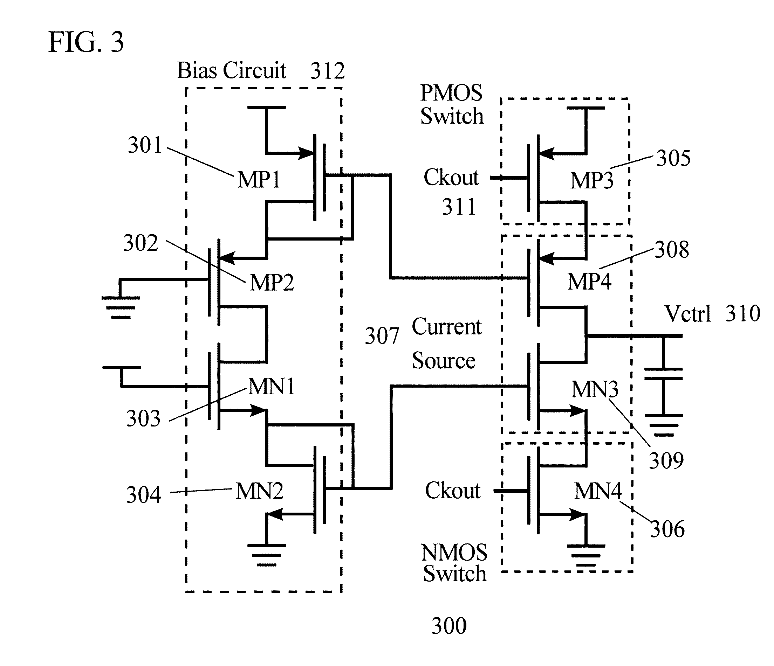

FIG. 3 is the detailed charge pump used in FIG.1. Current source 307 isolates Vctrl 310 from Ckout 311 to reduce the coupling effect; hence there will be less ripple on Vctrl which leads to less jitter. The bias circuit 312 provides the bias voltages 313, 314 to PMOS current source MP4 308 and NMOS current source MN3 309 respectively. MP3 305 and MN4 306 works as simple PMOS and NMOS switch which will be turned on or off depending upon Ckout 311 (buffer chain output 111). Output resistance R 204 mainly depends on the sizes of MP4 308 and MN3 309 transistors. So in our invention, we want to control the sizes of these transistors. For this purpose, a control circuitry is devised based on Vctrl voltage characteristics.

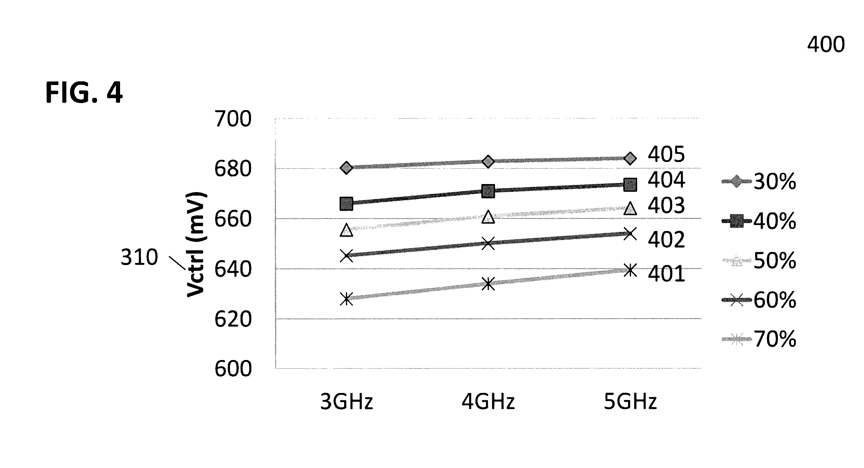

In FIG.4 the characteristics of Vctrl 410 is shown for 3 GHz to 5 GHz operating frequency range. Curve 401, 402, 403, 404 and 405 exhibit Vctrl 310 voltage level for 70%, 60%, 50%, 40% and 30% input duty cycle respectively. The characteristic of Vctrl 310 is linear for different frequencies and unique with respect to particular operating frequency and particular input duty cycle. In other words, if Vctrl 310 value is known, the operating frequency and input duty cycle can be derived from it. This property of Vctrl 310 is used to make the charge-pump 300 programmable.

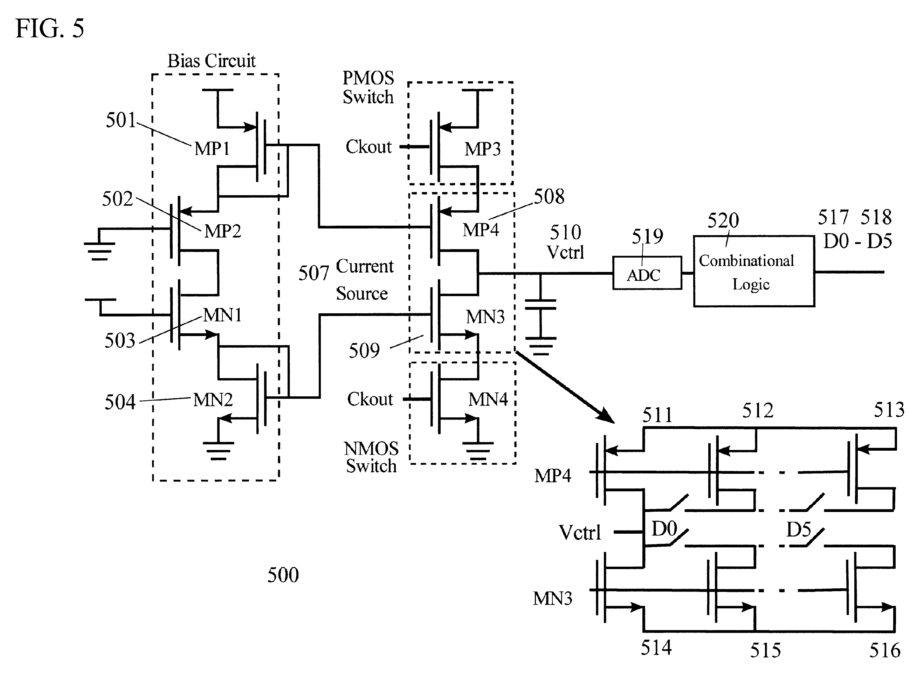

In FIG. 5, the schematic of the programmable charge-pump 500 where Vctrl 510 voltage value is converted into digital bits D0 517 to D5 518 using 6-bit analog-to-digital converter (ADC) 519 and combinational logic 520 which will in turn control the parallel transistors (e.g. 511- 516) of MP4 508 and MN3 509. As Vctrl 510 is unique for particular frequency and input duty cycle, ADC 519 does not need to run at the high-speed for quick sampling. ADC 519 sampling frequency depends on the fact how often input frequency and duty cycle changes due to PVT variations or desired functionality.

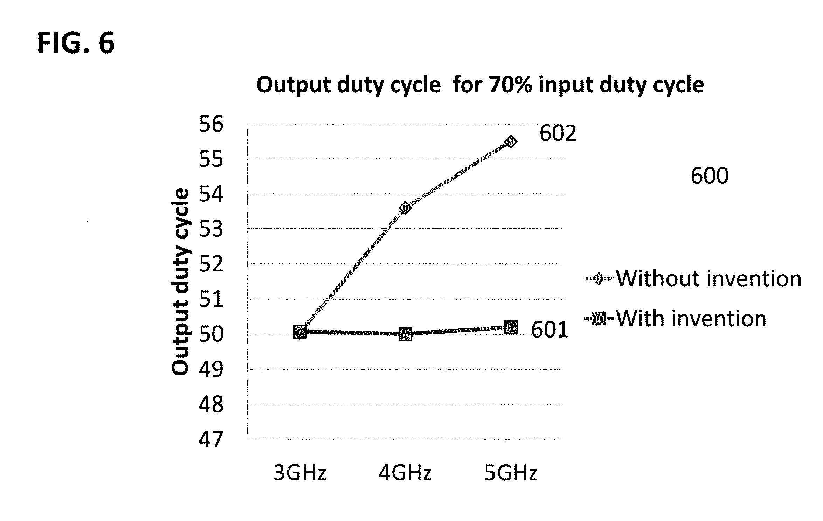

An example of the performance of the method (FIG. 5) to provide duty cycle correction using programmable charge pump is shown in FIG. 6. Curve 601 is the duty cycle variation curve for 70% input duty cycle error using an example of the method. Curve 601 exhibits approximately 50% output duty cycle with an error less than +/- 1% for frequency range from 3 GHz to 5 GHz. Curve 602 is the duty cycle variation curve without using proposed method and exhibit output duty cycle variation with an error larger than 10 % which is not acceptable for any synchronous electronic or integrated system.

The example of the method shown in FIG. 5 (in 65nm technology) can only correct the output duty cycle up to 5 GHz. The main bottleneck is the buffer stage 102. The classical design of the buffer stage 102 with increasing size of the consequent inverters 105, 106 cannot work beyond 5 GHz. At frequency of 6 GHz (clock period- 166 ps) with input duty cycle of 30% (49.8 ps on time), the input gate capacitors of big inverters 105, 106 cannot be charged or discharged properly by previous stage inverter 104 so sizes of large inverters 105, 106 have to be reduced beyond 5 GHz. This can be easily achieved by using additional bit which indicates if operating frequency is above 5 GHz.

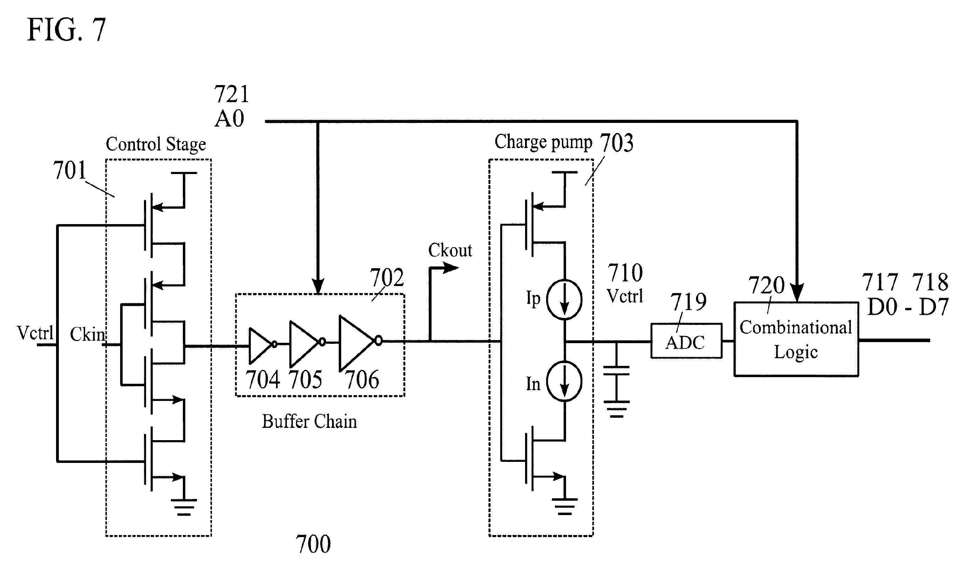

Another example of the method is shown in FIG.7 to correct the output duty cycle to 50% beyond 5 GHz operating frequency. A0 bit 721 is additional bit information to indicate if duty cycle corrector is running at 5 GHz or below operating frequency or at greater than 5 GHz operating frequency. The buffer chain 702 consists of programmable inverters 705, 706. Till 5 GHz, A0 bit 721 is 1 and normal operation works with large inverters 705, 706. Beyond 5 GHz, A0 bit 721 is 0 and some parallel transistors are switched off to lower the effective size of large inverters 705, 706 and therefore the gate capacitance of the programmed inverters 705, 706 also reduced.

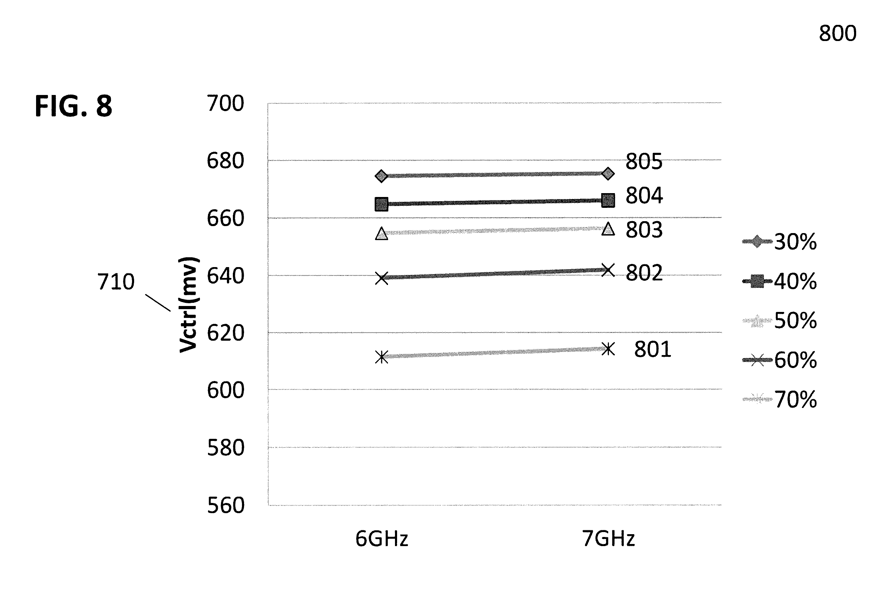

In FIG. 8 the characteristics of Vctrl 710 is shown for 6 GHz and 7 GHz operating frequency. Curve 801, 802, 803, 804 and 805 exhibit Vctrl 710 voltage level for 70%, 60%, 50%, 40% and 30% input duty cycle respectively. The characteristic of Vctrl is similar to FIG. 4 as it is also unique with respect to particular frequency and input duty cycle. The difference between FIG. 4 and FIG. 8 is the Vctrl voltage level. For example at 5 GHz Vctrl level is 640 mV for 70% input duty cycle in FIG. 4 while Vctrl level is 615 mV for 70% input duty cycle in FIG. 8. To differentiate from FIG. 4, A0 bit 721 is also used with combinational logic 720 as shown in an example of the method in FIG. 7. A0 bit 721 can decide which Vctrl voltage level has to be considered if operating frequency is beyond 5 GHz.

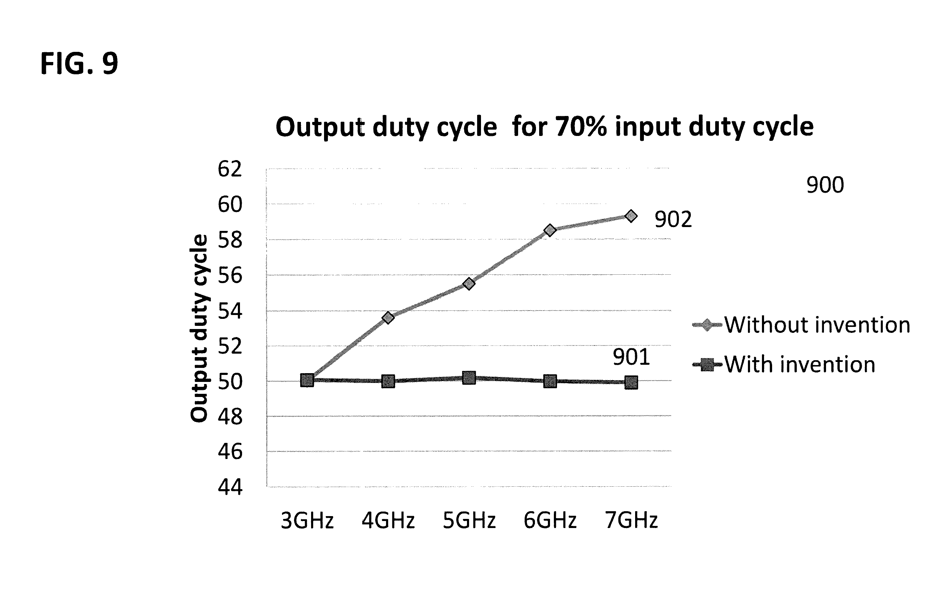

An example of the performance of the method (FIG. 7) to provide duty cycle correction using programmable charge pump and programmable buffer is shown in FIG. 9. The Curve 901 is the duty cycle variation curve for 70% input duty cycle error using an example of the method. The Curve 901 exhibits approximately 50% output duty cycle with an error less than +/- 1% for frequency range from 3 GHz to 7 GHz. Curve 902 is the duty cycle variation curve without using proposed method and exhibit output duty cycle variation with an error larger than 10 % which is not acceptable for any synchronous electronic or integrated system.

**Reference list**

| | | | |
|---|---|---|---|
| 1. | Synchronous electronic systems | 16. | ADC |
| 2. | DDR system | 17. | Combinational logic |
| 3. | Multi-phase clocking system | 18. | Gain |
| 4. | DDR3 | 19. | Bandwidth |
| 5. | GDDR5 | 20. | Operating frequency region |
| 6. | XDR | 21. | Information bit |
| 7. | Clock distribution | 22. | Programmable buffer chain |
| 8. | Buffer | 23. | Standard circuit topology |
| 9. | Inverter | 24. | Yield |
| 10. | Input duty cycle | 25. | Low voltage |
| 11. | Duty cycle error | 26. | Scalability |
| 12. | Control device | 27. | Current source |
| 13. | Buffer chain | 28. | Parallel NMOS devices |
| 14. | Charge pump | 29. | Parallel PMOS devices |
| 15. | Programmable charge pump | | |

## Claims

1. Method for correcting the duty cycle of a clock signal, comprising the steps of :
Detecting the input duty cycle and operating frequency of a clock signal by converting programmable charge pump output voltage to digital bits and dynamically adjusting the sizes of current source devices of a programmable charge pump based on the digitally decoded bits.

2. Method according to claim 1 wherein:
The current source is plurality of parallel PMOS devices; and said adjusting step includes the step of connecting the said parallel PMOS devices to the programmable charge pump output based on the digitally decoded bits.

3. Method according to claim 1 or 2 wherein:
The current source is plurality of parallel NMOS devices; and said adjusting step includes the step of connecting the said parallel NMOS devices to the charge pump output based on the digitally decoded bits.

4. Method according to one of the previous claims wherein:
Method includes an electronic device ADC which converts the output of the programmable charge pump into digital bits; and said adjusting step includes the detection step of the input duty cycle and the operating frequency of a clock signal.

5. Method according to one of the previous claims wherein:
Method includes an electronic device combinational logic; and said adjusting step includes the decoding step of digital bits used in detecting the input duty cycle and the operating frequency of a clock signal and providing digital control to connect parallel PMOS and NMOS devices of the current source used in programmable charge pump.

6. Method according to one of the previous claims wherein:
Method includes an electronic control device; and said adjusting step includes the adjustment of the duty cycle of a clock signal based on the output of a programmable charge pump.

7. Method according to one of the previous claims wherein:
Method includes a buffer chain comprising odd number of inverters; and said adjusting step includes obtaining a full swing clock signal with corrected duty cycle.

8. Method according to one of the previous claims, comprising the steps of :
Detecting the input duty cycle and operating frequency of a clock signal by converting programmable charge pump output voltage to digital bits and dynamically adjusting the sizes of current source devices of a programmable charge pump based on the digitally decoded bits and/or adjusting the sizes of inverters of a programmable charge pump based on an information bit which carry operating frequency region information.

9. Method according to claim 8 wherein:
Method includes an information bit of known frequency operating region; and said adjusting step includes the adjusting the sizes of the inverters in a buffer chain based on the frequency operating region.

10. Method according to claim 8 wherein:
Method includes an information bit of known frequency operating region; and said adjusting step includes the adjusting the decoding logic of the combinational logic based on the frequency operating region.

11. Method according to claim 9 or 10 wherein:
An information bit of known frequency operating region is generated within the same electronic device.

12. Method according to claim 9or 10 wherein:
An information bit of known frequency operating region is generated from different electronic device or stored in different electronic device.

13. The device **characterised by** the method described according to one of the preceding claims 1-12 and its use in any synchronous electronic device or any memory unit, particular of a DDR-memory type.
